# EUROPÄISCHE PATENTSCHRIFT

(11) **EP 0 789 982 B1**
(45) Veröffentlichungstag und Bekanntmachung des Hinweises auf die Patenterteilung: **26.08.1998**
(21) Anmeldenummer: 95935440.8
(22) Anmeldetag: 07.10.1995
(51) Int. Cl.: H05K 7/18

(54) **RAHMENGESTELL FÜR EINEN SCHALTSCHRANK**
FRAME FOR A SWITCHGEAR CABINET
BAIE POUR ARMOIRE DE DISTRIBUTION

(30) Priorität: 05.11.1994 DE 4439544
(43) Veröffentlichungstag der Anmeldung: 20.08.1997
(73) Patentinhaber: Rittal-Werk Rudolf Loh GmbH & Co. KG, 35745 Herborn (DE)
(72) Erfinder: BESSERER, Horst, D-35745 Herborn (DE); HARTEL, Marc, D-35447 Reiskirchen (DE); ZACHRAI, Jürgen, D-35690 Dillenburg (DE)
(74) Vertreter: Fleck, Hermann-Josef, Dr.-Ing.
(86) Internationale Anmeldenummer: EP9503958
(87) Internationale Veröffentlichungsnummer: WO9614728

(56) Entgegenhaltungen:
- DE-A- 3 917 985
- DE-U- 9 216 156
- FR-A- 2 685 137
- US-A- 4 412 708

## Beschreibung

Die Erfindung betrifft ein Rahmengestell für einen Schaltschrank, das aus horizontalen und vertikalen Rahmenschenkeln sowie Tiefenstreben zusammengesetzt ist und dessen offene Seiten mittels Wandelementen und mindestens einer Türe verschließbar sind.

Bei den bekannten Rahmengestellen dieser Art bilden in der Regel zwei senkrecht zueinander stehende Profilseiten der Rahmenschenkel Außenseiten des Rahmengestelles und eine Außenkante desselben. Für die Anlenkung der Türe sind besondere Scharnierelemente an den vertikalen Rahmenschenkeln anzubringen (siehe z.B. FR-A-2 685 137). Auf der Schließseite der Türe sind getrennte Schließelemente zusätzlich anzubringen. Dabei ist oft die Anschlagseite der Türe am Rahmengestell festgelegt und kann am Einsatzort des Schaltschrankes nicht mehr geändert werden. Außerdem liegt in der Regel auch fest, welche offene Seite des Rahmengestelles mit der Türe verschließbar sein soll.

Es ist Aufgabe der Erfindung, bei einem Rahmengestell der eingangs erwähnten Art ohne zusätzliche Scharnier- und Schließelemente am Rahmengestell die Türe anzubringen, wobei die Scharnier- und Schließseite der Türe einfach vertauscht werden kann und wobei die für eine Seite des Rahmengestelles vorgesehene Türe auch an der gegenüberliegenden Seite des Rahmengestelles angebracht werden kann.

Diese Aufgabe wird nach der Erfindung dadurch gelöst, daß die Tiefenstreben auf der Vorder- und/oder der Rückseite des Rahmengestelles über die horizontalen und vertikalen Rahmenschenkel vorstehende Verlängerungen aufweisen, die mit vertikal ausgerichteten Aufnahmen für Scharnierbolzen oder Schließbolzen der Türe versehen sind.

Bei dieser Ausgestaltung der Tiefenstreben kann eine Türe an der Vorder- und/oder Rückseite des Rahmengestelles angebracht werden, wobei die Türe links oder rechts angeschlagen werden kann. Die Scharnierbolzen der Schließseite werden ebenso von den Aufnahmen der Verlängerungen aufgenommen wie die Schließbolzen, so daß die Anschlagseite beliebig gewählt werden kann. Die Tiefenstreben übernehmen mit dieser Ausgestaltung die Funktionen der bei den bekannten Rahmengestelle zusätzlich angebrachten Scharnier- und Schließelemente.

Die Verlängerungen der Tiefenstreben können dabei einstückig mit den Tiefenstreben ausgebildet sein. Die Verlängerungen können auch als getrennte Eckteile ausgebildet sein, die mit den anschließenden horizontalen und vertikalen Rahmenschenkeln und der zugeordneten Tiefenstrebe verbunden sind.

Ist nach einer Ausgestaltung vorgesehen, daß die Verlängerung zusätzlich mit einer horizontal ausgerichteten Aufnahme versehen ist, dann können einheitlich ausgebildete Tiefenstreben oder Verlängerungen an allen Seitenkanten oder Ecken des Rahmengestelles verwendet werden.

Eine Ausgestaltung der Türe zum Anbringen an dem Rahmengestell ist dadurch gekennzeichnet, daß die Türe auf der Innenseite im Bereich der Ecken mit Lagerblöcken versehen ist, die eine durchgehende, vertikale und teilweise mit einem Innengewinde versehene Führung für einen Scharnierbolzen oder einen Schließbolzen trägt.

Dabei ist bei der Verwendung von einheitlich ausgelegten Lagerblöcken die Anbringung an der Türe so, daß auf der Scharnierseite der Türe die Lagerblöcke so angebracht sind, daß die Innengewinde der zugeordneten horizontalen Seite der Türe abgekehrt sind, während sie auf der Schließseite der Türe den zugeordneten horizontalen Seiten der Türe zugekehrt sind.

Auf der Schließseite der Türe kann eine weitere Vereinfachung dadurch erreicht werden, daß die Schließbolzen als Schubstangen einer Schubstangen-Verschlußeinrichtung ausgebildet sind.

Eine eindeutige Führung der Schubstangen in den Lagerblöcken wird dadurch erreicht, daß der Durchmesser der Schubstangen an den Durchmesser der Führungen in den Lagerblöcken angepaßt ist.

Damit ohne Beeinflussung dieser Führung die Scharnierbolzen in die Lagerblöcke eingeschraubt werden können, ist weiterhin vorgesehen, daß das Innengewinde der Lagerblöcke einen Innendurchmesser aufweist, der größer ist als der Durchmesser der Führung und daß die Scharnierbolzen entsprechend angepaßte Führungsabschnitte und Gewindeteile aufweisen.

Soll nur eine Seite des Rahmengestelles mit einer Türe verschlossen werden, dann kann vorgesehen sein, daß getrennte Eckteile vorgesehen sind, die ohne Verlängerung bündig mit den angrenzenden horizontalen und vertikalen Rahmenschenkeln abschließen und an der Vorder- oder Rückseite des Rahmengestelles angebracht sind, oder daß Tiefenstreben vorgesehen sind, die nur an einem Ende mit einer Verlängerung versehen sind. Das Rahmengestell hat dann nur an einer Seite vorstehende Verlängerungen zum Anbringen einer Türe.

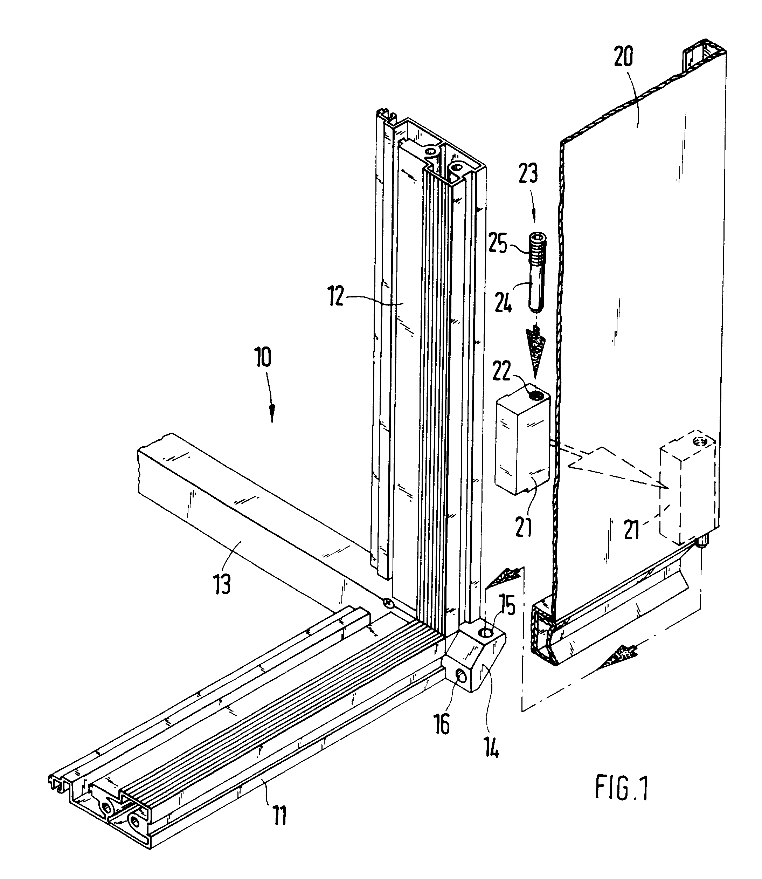

Die Erfindung wird anhand eines in den Zeichnungen dargestellten Ausführungsbeispiels näher erläutert. Es zeigen:
- Fig. 1: den unteren rechten Teil eines Rahmengestelles, an dem eine Türe angelenkt wird, und
- Fig. 2: denselben unteren Teil eines Rahmengestelles mit der Verwendung zur Aufnahme eines Schließbolzens der Türe.
Von dem Rahmengestell 10 des Schaltschrankes sind in Fig. 1 der horizontale Rahmenschenkel 11, der vertikale Rahmenschenkel 12 und die Tiefenstrebe 13 gezeigt, welche die untere rechte Ecke auf der Vorderseite des Rahmengestelles 10 bilden. Die Tiefenstrebe 13 steht mit einer Verlängerung 14 über den horizontalen Rahmenschenkel 11 und den vertikalen Rahmenschenkel 12 vor und dies im Bereich aller Ecken des Rahmengestelles 10, so daß sowohl auf der Vorderseite als auch der Rückseite des Rahmengestelles 10 eine Türe 20 angebracht werden kann.

Die Verlängerungen 14 können einstückig mit den Tiefenstreben 13 ausgebildet sein. Sie können aber auch als getrennte Eckteile mit den anschließenden horizontalen und vertikalen Rahmenschenkeln 11 und 12 sowie der zugeordneten Tiefenstrebe 13 verbunden sein.

Die Verlängerungen 14 sind mit einer vertikal ausgerichteten Aufnahme 15 für einen Scharnierbolzen 23 versehen. Tragen die Verlängerungen 14 auch eine senkrecht zu der Aufnahme 15 stehende horizontale Aufnahme 16, dann können an allen Seitenkanten des Rahmengestelles 10 einheitliche Tiefenstreben 13 oder an allen Ecken des Rahmengestelles 10 einheitliche Eckteile verwendet werden.

Die Türe 20 trägt auf der Innenseite in allen Eckbereichen Lagerblöcke 21, die mit einer durchgehenden Führung 26 versehen ist, welche an einem Ende mit einem im Durchmesser vergrößerten Innengewinde 22 versehen ist.

Auf der in Fig. 1 dargestellten Scharnierseite sind die Lagerblöcke 21 so an der Türe 20 angebracht, daß das Innengewinde 22 der zugekehrten horizontalen Seite der Türe 20 abgekehrt ist. In die Lagerblöcke 21 werden Scharnierbolzen 23 eingeschraubt, die mit einem auf die Führung 26 und die Aufnahme 15 angepaßten Führungsabschnitt 24 und einem auf das Innengewinde 22 abgestimmten Gewindeteil 25 aufweist. Der Scharnierbolzen 23 wird so weit in den Lagerblock 21 eingeschraubt, daß er in die Aufnahme 15 eingeführt wird. An der oberen Ecke des Rahmengestelles 10 wird die Türe 20 in gleicher Weise mit der Verlängerung 14 verbunden und angelenkt. Da das Rahmengestell 10 an allen vier Ecken vorstehende Verlängerungen 14 aufweist, kann die Türe 20 auf diese Weise links oder rechts auf der Vorderseite oder Rückseite des Rahmengestelles 10 angelenkt werden. Die Vorder- und Rückseite des Rahmengestelles kann auch mit zwei Türen verschlossen werden.

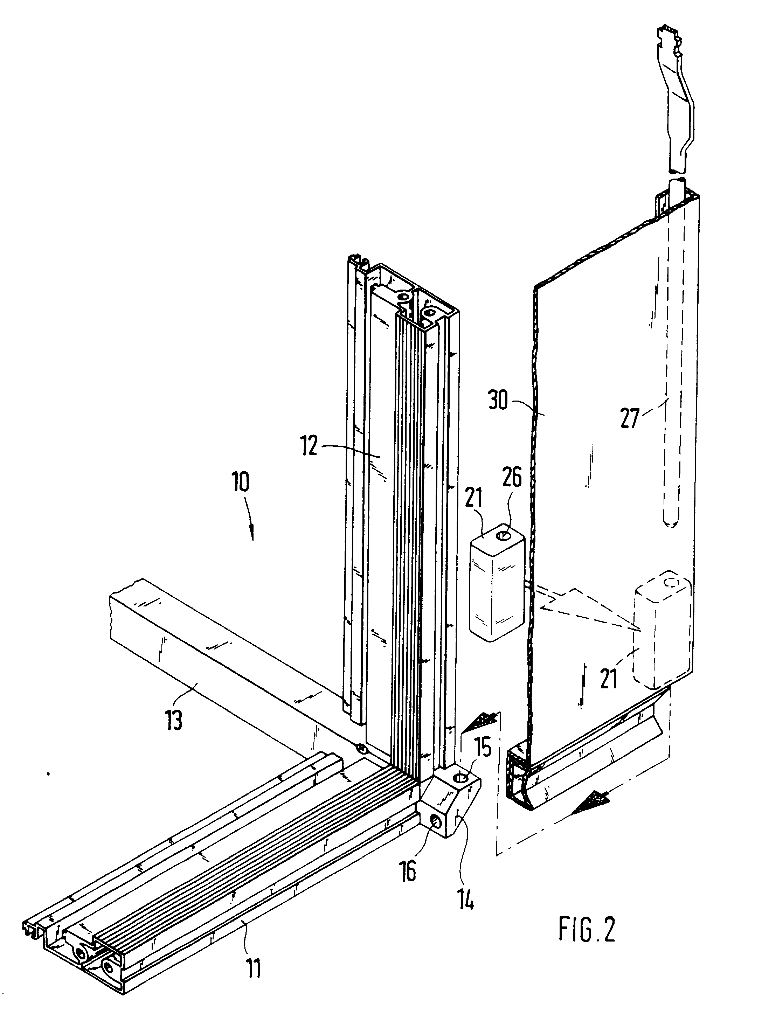

Auf der Schließseite der Türe 20 werden ebenfalls zwei Lagerblöcke 21 angebracht, diesmal jedoch so, daß die Innengewinde 22 den zugekehrten horizontalen Seiten der Türe 20 zugekehrt sind, wie Fig. 2 zeigt. Als Schließeinrichtung ist an der Türe 20 ein an sich bekanntes Schubstangenschloß angebracht, dessen Schubstangen die Schließbolzen 27 bilden. Diese Schließbolzen 27 sind im Durchmesser auf die Führungen 26 der Lagerblöcke 21 abgestimmt und darin verstellbar geführt. Im Schließzustand des Schubstangenschlosses werden die Schubstangen aus den Lagerblöcken 21 heraus in die Aufnahmen 15 der Verlängerungen 14 eingeführt. Das Schubstangenschloß hat zwei gegenläufig verstellbare Schubstangen, so daß die Türe 20 unten und oben verriegelt wird. Die Türe 20 trägt also vier Lagerblöcke 21, die einheitlich ausgebildet, jedoch um 180° an der Scharnier- und Schließseite verdreht angebracht sind. Soll nur eine Seite des Rahmengestelles 10 mit einer Türe 20 verschlossen werden, dann wird vorgesehen, daß getrennte Eckteile vorgesehen sind, die ohne Verlängerung bündig mit den angrenzenden horizontalen und vertikalen Rahmenschenkeln abschließen und an der Vorder- oder Rückseite des Rahmengestelles angebracht sind, oder daß Tiefenstreben vorgesehen sind, die nur an einem Ende mit einer Verlängerung versehen sind. Das Rahmengestell 10 kann damit so aufgebaut werden, daß entweder nur an der Vorderseite oder nur an der Rückseite des Rahmengestelles 10 Verlängerungen 14 zum Anbringen einer Türe 20 vorstehen.

## Patentansprüche

1. Rahmengestell für einen Schaltschrank, das aus horizontalen und vertikalen Rahmenschenkeln sowie Tiefenstreben zusammengesetzt ist und dessen offene Seiten mittels Wandelementen und mindestens einer Türe verschließbar sind,
dadurch gekennzeichnet,
daß die Tiefenstreben (13) auf der- Vorder- und/oder der Rückseite des Rahmengestelles über die horizontalen und vertikalen Rahmenschenkel (11,12) vorstehende Verlängerungen (14) aufweisen, die mit vertikal ausgerichteten Aufnahmen (15) für Scharnierbolzen (23) oder Schließbolzen (27) der Türe (20) versehen sind.

2. Rahmengestell nach Anspruch 1,
dadurch gekennzeichnet,
daß die Verlängerungen (14) einstückig mit den Tiefenstreben (13) verbunden sind.

3. Rahmengestell nach Anspruch 1,
dadurch gekennzeichnet,
daß die Verlängerungen (14) von den Tiefenstreben (13) getrennte Eckteile sind, die mit den anschließenden horizontalen und vertikalen Rahmenschenkeln (11,12) und der zugeordneten Tiefenstrebe (13) verbunden sind.

4. Rahmengestell nach einem der Ansprüche 1 bis 3,
dadurch gekennzeichnet,
daß die Verlängerung (14) zusätzlich mit einer horizontal ausgerichteten Aufnahme (16) versehen ist.

5. Rahmengestell nach einem der Ansprüche 1 bis 4,
dadurch gekennzeichnet,
daß die Türe (20) auf der Innenseite im Bereich der Ecken mit Lagerblöcken (21) versehen ist, die eine durchgehende, vertikale und teilweise mit einem Innengewinde (22) versehene Führung (26) für einen Scharnierbolzen (23) oder einen Schließbolzen (27) trägt.

6. Rahmengestell nach Anspruch 5,
dadurch gekennzeichnet,
daß auf der Scharnierseite der Türe (20) die Lagerblöcke (21) so angebracht sind, daß die Innengewinde (22) der zugeordneten horizontalen Seite der Türe (20) abgekehrt sind, während sie auf der Schließseite der Türe (20) den zugeordneten horizontalen Seiten der Türe (20) zugekehrt sind.

7. Rahmengestell nach einem der Ansprüche 1 bis 6,
dadurch gekennzeichnet,
daß die Schließbolzen (27) als Schubstangen einer Schubstangen-Verschlußeinrichtung ausgebildet sind.

8. Rahmengestell nach einem der Ansprüche 5 bis 7,
dadurch gekennzeichnet,
daß das Innengewinde (22) der Lagerblöcke (21) einen Innendurchmesser aufweist, der größer ist als der Durchmesser der Führung (26) und daß die Scharnierbolzen (23) entsprechend angepaßte Führungsabschnitte (24) und Gewindeteile (25) aufweisen.

9. Rahmengestell nach Anspruch 7,
dadurch gekennzeichnet,
daß der Durchmesser der Schubstangen an den Durchmesser der Führungen (26) in den Lagerblöcken (21) angepaßt ist.

10. Rahmengestell nach Anspruch 3,
dadurch gekennzeichnet,
daß getrennte Eckteile vorgesehen sind, die ohne Verlängerung bündig mit den angrenzenden horizontalen und vertikalen Rahmenschenkeln (11,12) abschließen und an der Vorder- oder Rückseite des Rahmengestelles (10) angebracht sind.

11. Rahmengestell nach Anspruch 2,
dadurch gekennzeichnet,
daß Tiefenstreben (13) vorgesehen sind, die nur an einem Ende mit einer Verlängerung (14) versehen sind.

## Claims

1. Framework for a switchgear cabinet, which comprises horizontal and vertical frame members as well as depth bars, and the open sides of which are closable by means of wall members and at least one door, characterised in that the depth bars (13) have, on the front side and/or on the rear side of the framework, extensions (14) which protrude beyond the horizontal and vertical frame members (11,12) and are provided with vertically aligned receiving means (15) for accommodating hinge pins (23) or closing pins (27) of the door (20).

2. Framework according to claim 1, characterised in that the extensions (14) are integrally connected to the depth bars (13).

3. Framework according to claim 1, characterised in that the extensions (14) are corner members, which are separated from the depth bars (13) and are connected to the adjacent horizontal and vertical frame members (11,12) and the associated depth bar (13).

4. Framework according to one of claims 1 to 3, characterised in that the extension (14) is additionally provided with a horizontally aligned receiving means (16).

5. Framework according to one of claims 1 to 4, characterised in that the door (20) is provided with bearing blocks (21) on the internal surface in the region of the corners, which bearing blocks are supported by a continuous, vertical guide (26), which is partially provided with an internal thread (22), for guiding a hinge pin (23) or a closing pin (27).

6. Framework according to claim 5, characterised in that the bearing blocks (21) are so mounted on the hinge side of the door (20) that the internal threads (22) face away from the associated horizontal side of the door (20), while they face the associated horizontal sides of the door (20) on the closing side of the door (20).

7. Framework according to one of claims 1 to 6, characterised in that the closing pins (27) are configured as push-rods of a push-rod closing arrangement.

8. Framework according to one of claims 5 to 7, characterised in that the internal thread (22) of the bearing blocks (21) has an internal diameter which is greater than the diameter of the guide (26), and in that the hinge pins (23) have correspondingly adapted guide portions (24) and threaded parts (25).

9. Framework according to claim 7, characterised in that the diameter of the push-rods is adapted to the diameter of the guides (26) in the bearing blocks (21).

10. Framework according to claim 3, characterised in that separate corner members are provided, which terminate flush with the adjoining horizontal and vertical frame members (11,12) without any extension and are mounted on the front or rear side of the framework (10).

11. Framework according to claim 2, characterised in that depth bars (13) are provided, which are only provided with an extension (14) at one end.

## Revendications

1. Baie pour armoire de distribution, laquelle est composée de branches de cadre horizontales et verticales ainsi que d'entretoises de profondeur, et dont les côtés ouverts peuvent être fermés au moyen d'éléments de paroi et d'au moins une porte,
caractérisée
en ce que les entretoises de profondeur (13) présentent, côté avant et côté arrière de la baie, des prolongements (14) faisant protubérance par rapport aux branches de cadre horizontales et verticales (11, 12), prolongements (14) qui présentent des logements récepteurs (15) de direction verticale pour des boulons de charnière (23) ou des verrous de fermeture (27) de la porte (20).

2. Baie suivant la revendication 1,
caractérisée
en ce que les prolongements (14) sont reliés aux entretoises de profondeur (15) et en font partie intégrante.

3. Baie suivant la revendication 1,
caractérisée
en ce que en ce que les prolongements (14) sont constitués par les cornières indépendantes des entretoises de profondeur (13), qui sont reliées aux les branches de cadre verticales et horizontales contiguës et à l'entretoise de profondeur associée (13).

4. Baie suivant l'une quelconque des revendications de 1 à 3,
caractérisée
en ce que le prolongement (14) est, en addition, doté d'un logement de réception disposé horizontalement.

5. Baie suivant l'une quelconque des revendications de 1 à 4,
caractérisée
en ce que la porte (20) est, du côté intérieur dans la région des angles, dotée de blocs de palier (21) qui présentent un guidage vertical (26) allant de part en part et doté partiellement d'un filetage intérieur (22), guidage qui est destiné à guider un boulon de charnière (23) ou un verrou de fermeture (27).

6. Baie suivant la revendication 1,
caractérisée
en ce que du côté de la charnière de la porte (20), les blocs de palier (21) sont montés de manière telle que les filetages intérieurs (22) sont disposés en opposition au côté horizontal associé de la porte (20), tandis que du côté fermeture de la porte (20), ils font face aux côtés horizontaux associés de la porte (20).

7. Baie suivant l'une quelconque des revendications de 1 à 6,
caractérisée
en ce que les verrous de fermeture ont la forme de tringles de poussée d'un mécanisme de fermeture à tringles de poussée.

8. Baie suivant l'une quelconque des revendications de 5 à 7,
caractérisée
en ce que le filetage intérieur (22) des blocs de palier (21) présente un diamètre intérieur qui est supérieur au diamètre du guidage (26), et en ce que les verrous de fermeture (25) présentent des tronçons de guidage (24) et des portions filetées (25) adaptés en conséquence.

9. Baie suivant la revendication 7,
caractérisée
en ce que le diamètre des tringles de poussée est adapté au diamètre des guidages (26) dans les blocs de palier (21).

10. Baie suivant la revendication 3,
caractérisée
en ce que des cornières séparées sont prévues, qui sans prolongement se terminent à fleur avec les branches de cadre (11, 12) limitrophes horizontaux et verticaux et qui sont montées sur le côté avant ou arrière de la baie (10).

11. Baie suivant la revendication 2,
caractérisée
en ce que des entretoises de profondeur (13) sont prévues, qui à une extrémité seulement sont munies d'un prolongement (14).
